# FASCICULE DE BREVET EUROPEEN

(11) **EP 0 366 562 B1**
(45) Date de publication et mention de la délivrance du brevet: **09.03.1994**
(21) Numéro de dépôt: 89402975.0
(22) Date de dépôt: 27.10.1989
(51) Int. Cl.: H03H 9/09, H03H 9/10

(54) **Dispositif démontable de support d'un résonateur piézoélectrique à l'intérieur d'un boîtier**
Zerlegbare Haltevorrichtung eines piezoelektrischen Resonators in einem Gehäuse
Detachable holding device for a piezoelectric resonator inside a housing

(30) Priorité: 28.10.1988 FR 8814197
(43) Date de publication de la demande: 02.05.1990
(73) Titulaire: ECOLE NATIONALE SUPERIEURE DE MECANIQUE ET DES MICROTECHNIQUES, F-25030 Besançon (FR)
(72) Inventeur: Besson, Raymond, F-25000 Besançon (FR); Delaite, Richard, F-90000 Belfort (FR); Renard, Georges, F-25410 St Vit (FR); Valentin, Jean-Pascal, F-25115 Pouilley les Vignes (FR); Vaterkowski, Jean-Louis, F-70190 Rioz (FR)
(74) Mandataire: Thévenet, Jean-Bruno

(56) Documents cités:
- FR-A- 2 583 584

## Description

La présente invention, qui est due aux travaux de Messieurs R. Besson, R. Delaite, G. Renard, J.P. Valentin et J.L. Vaterkowski du Laboratoire de Chronométrie, Electronique et Piézoélectricité de l'Ecole Nationale Supérieure de Mécanique et des Microtechniques de l'Université de Franche-Comté - Besancon, concerne les structures mécaniques de support de résonateurs piézoélectriques et plus particulièrement un dispositif démontable de support de résonateur piézoélectrique à l'intérieur d'un boîtier, comprenant quatre pinces indépendantes identiques en forme de U qui sont réalisées en un matériau dont le coefficient de dilatation dans le sens axial du résonateur est pratiquement identique à celui du matériau constituant le résonateur et qui coopèrent chacune avec une paire de ressorts constitués chacun par un fil métallique rond en un alliage à haute limite élastique, l'ensemble des pinces et des ressorts présentant une symétrie par rapport à deux plans axiaux du résonateur perpendiculaires entre eux, ainsi que par rapport à un plan radial médian du résonateur.

On connait divers exemples de résonateurs piézoélectriques.

Selon un premier exemple classique, un cristal résonateur est constitué par une plaquette de quartz plan-convexe ou bi-convexe à contour circulaire, sur les faces frontales de laquelle sont déposées directement des électrodes métalliques, dites électrodes adhérentes.

Selon un autre exemple de réalisation, la plaquette de quartz à électrodes adhérentes est limitée extérieurement par une couronne en quartz servant au support du cristal-résonateur.

Selon encore un autre exemple de réalisation, le cristal-résonateur est relié à une couronne en quartz par des ponts taillés dans la masse. Les électrodes peuvent être adhérentes ou non adhérentes. Dans ce dernier cas, les électrodes sont déposées sur des plaquettes de quartz de même coupe que le cristal et de forme similaire et seules les couronnes des plaquettes-support d'électrodes sont en contact avec la couronne du cristal vibrant.

Quel que soit le type de résonateur utilisé, il est en général nécessaire d'incorporer ce résonateur dans un boîtier de protection qui, s'il est étanche, permet en outre de créer un espace dans lequel règne un vide plus ou moins poussé qui améliore les conditions de fonctionnement du résonateur et partant la qualité de celui-ci.

Le boîtier et le cristal-résonateur présentent cependant des caractéristiques mécaniques et thermiques différentes, de sorte qu'il est nécessaire de réaliser une structure mécanique spécifique permettant de limiter l'influence des perturbations extérieures en rapportant le minimum de contraintes au centre du cristal.

On a déjà proposé par le document US-A-4 705 982 de réaliser un dispositif de support d'un résonateur piézoélectrique à l'intérieur d'un boîtier applicable à différents types de résonateurs piézoélectriques, conçu pour minimiser les variations relatives de fréquence du résonateur sous l'influence de perturbations accélérométriques, thermiques ou de pression, afin de conférer au résonateur une stabilité maximale dans le temps et un vieillissement aussi faible que possible.

Selon ce dispositif de support connu, des première et deuxième demi-coques identiques de positionnement du résonateur qui sont en un matériau de même nature et de même coupe que celui composant le résonateur, présentent chacune la forme d'un croisillon et comportent chacune quatre branches dont les extrémités libres définissent des cornières présentant une portée horizontale de faible surface légèrement rehaussée par rapport à la partie centrale de la demi-coque correspondante et une branche verticale de retenue de la tranche du résonateur; et quatre brides indépendantes identiques d'immobilisation des deux demi-coques qui présentent la forme d'un U couché et comportent chacune aux extrémités de chaque branche du U deux éléments d'arrêt portant sur deux branches superposées des deux demi-coques, sur les faces des branches opposées auxdites portées horizontales coopèrent avec quatre paires de ressorts de suspension reliant les quatre brides d'immobilisation au boîtier.

Dans un tel dispositif connu de support d'un résonateur, les ressorts de suspension des brides de retenue des demi-coques en forme de croix sont reliés directement au boîtier et immobilisés par une de leurs extrémités à la jonction entre différentes parois constituant le boîtier. Ceci empêche d'obtenir un découplage complet entre le boîtier, dont le rôle principal est de maintenir le vide dans l'espace interne au boîtier, et qui peut être soumis à des chocs ou déformations, et la suspension proprement dite qui doit rester la plus symétrique possible. Par ailleurs, la réalisation de demi-coques en forme de croix dans un matériau de même nature et de même coupe que celui composant le résonateur, constitue une contrainte en matière de coût de fabrication.

La présente invention vise précisément à remédier aux inconvénients précités et à permettre la réalisation d'un dispositif de support de résonateur dans un boîtier qui soit plus simple et moins coûteux à fabriquer que les dispositifs existants, et qui de plus assure un découplage plus efficace entre le boîtier et les organes de suspension du résonateur, en autorisant par ailleurs un démontage et un remontage aisés des organes de suspension.

Ces buts sont atteints grâce à un dispositif de support du type défini en tête de la description, caractérisé en ce qu'il comprend en outre une pièce cylindrique amovible placée à l'intérieur du boîtier au voisinage de la paroi latérale du boîtier, s'étendant sur toute la hauteur de l'espace interne défini entre les parois supérieure et inférieure du boîtier et présentant sur sa face interne une gorge circulaire située dans un plan médian parallèle aux parois supérieure et inférieure du boîtier, en ce que pour chaque paire de ressorts coopérant avec une même pince, l'un des ressorts est engagé par une première portion dans une rainure supérieure formée dans la face arrière plane de ladite pince à la partie supérieure de celle-ci, et par une seconde portion dans ladite gorge circulaire tandis que l'autre ressort est engagé par une première portion dans une rainure inférieure formée dans la face arrière plane de ladite pince à la partie inférieure de celle-ci, et par une seconde portion dans ladite gorge circulaire, et lesdites secondes portions des ressorts engagées dans ladite gorge circulaire sont solidarisées entre elles et se projettent en arrière par rapport à la face arrière de ladite pince, et en ce que les faces internes des pinces sensiblement perpendiculaires à la face arrière desdites pinces reposent directement sur la périphérie des faces externes supérieure et inférieure du résonateur ou des disques de support des électrodes du résonateur.

De préférence, la gorge circulaire présente une forme annulaire à section rectangulaire.

La pièce cylindrique est métallique et présente un épaulement à l'une de ses extrémités pour ménager un espace libre entre la paroi latérale du boîtier et la pièce cylindrique sur la majeure partie de la hauteur de celle-ci.

Selon une caractéristique particulière, les faces internes des pinces sensiblement perpendiculaires à la face arrière présentent une surface régulière en contact avec les faces externes supérieure et inférieure du résonateur ou des disques de support des électrodes du résonateur sur une zone s'étendant radialement sur une distance de l'ordre de 1 à 2 mm.

De préférence, afin de limiter les contraintes, des évidements sont formés dans les parois des disques de support des électrodes du résonateur dans des zones prolongeant radialement vers le centre du résonateur les zones au niveau desquelles les pinces sont en contact avec les faces externes supérieure et inférieure des disques de support sur une distance de l'ordre de 1 à 2 mm.

De façon plus particulière, les ressorts présentent une interruption au niveau de leur première portion engagée dans une rainure de la face arrière de la pince avec laquelle ils coopèrent, sont symétriques par rapport à un plan radial vertical situé au niveau de ladite interruption et présentent une configuration telle que chaque demi-ressort divisé par ledit plan de symétrie radial vertical comprend une première partie horizontale rectiligne destinée à venir s'encastrer dans une rainure de la pince réceptrice, une partie verticale courbe disposée à l'extérieur de la pince réceptrice dans un plan formant un angle de 45° par rapport au plan de symétrie du ressort, et une seconde partie horizontale qui est reliée à l'extrémité de la partie verticale courbe éloignée de la première partie horizontale et constitue une partie de ladite seconde portion située en arrière par rapport à la première partie horizontale rectiligne qui constitue elle-même une partie de ladite première portion.

D'autres caractéristiques et avantages de l'invention ressortiront de la description suivante d'un mode particulier de réalisation, donné à titre d'exemple, en référence aux dessins annexés sur lesquels :
- la figure 1 est une vue en coupe axiale selon un plan de symétrie d'un boîtier incorporant un dispositif de support démontable de résonateur à l'intérieur d'un boîtier, conformément à l'invention,
- la figure 2 est une vue en coupe du dispositif de la figure 1 selon la ligne II-II de cette figure 1, et
- la figure 3 est une vue en perspective montrant une partie des moyens de support selon l'invention avec une pince et une paire de ressorts qui coopèrent d'une part avec une pièce cylindrique intermédiaire distincte du boîtier et d'autre part, directement avec le résonateur.

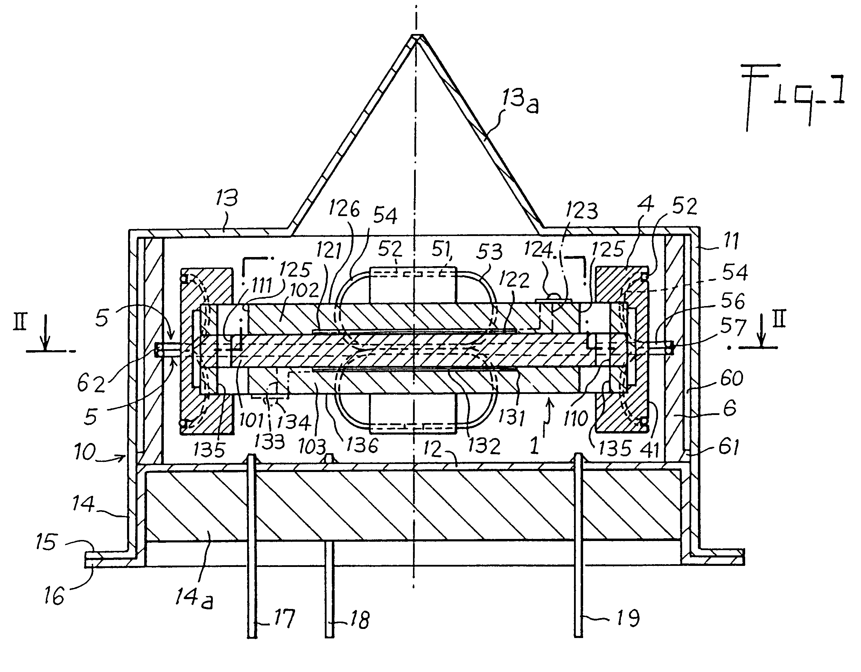

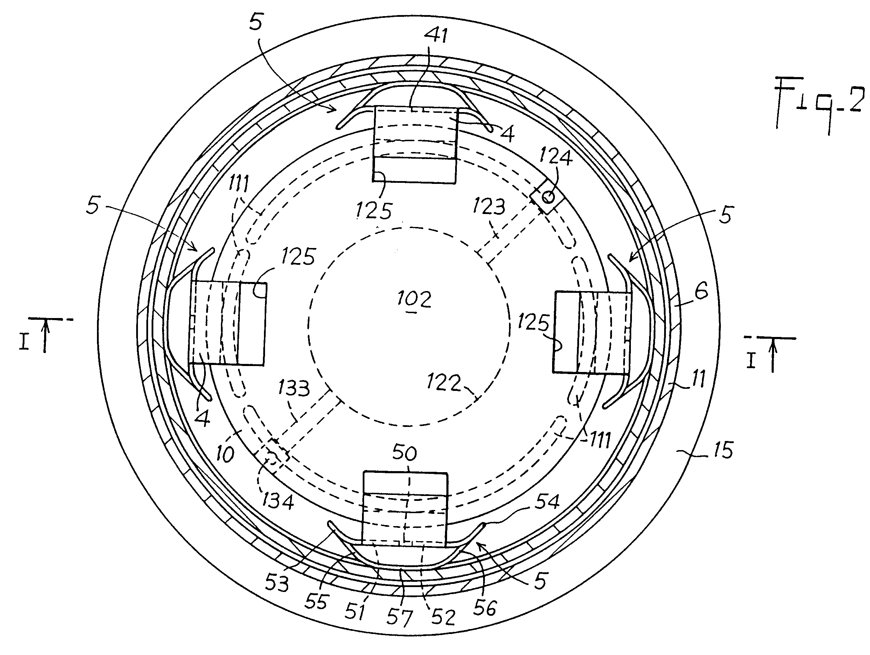

Les figures 1 et 2 montrent l'ensemble des moyens démontables de support d'un résonateur 1 à l'intérieur d'un boîtier de protection 10.

Le boîtier 10 comporte de façon classique un capot présentant une paroi latérale cylindrique 11 et une partie supérieure 13 munie d'un prolongement 13a muni d'une fente qui permet de faire le vide à l'intérieur du boîtier avant d'être obturée de façon hermétique. Le capot repose par une aile annulaire 15 sur une aile annulaire 16 d'une embase, les deux ailes 15, 16 étant prévues pour être fixées de façon étanche l'une à l'autre. L'embase présente une paroi latérale cylindrique 14 de faible hauteur qui vient s'engager à l'intérieur du capot, et une paroi plane supérieure 12 qui est traversée par des broches de connexion isolées 17, 18, 19. Une matière isolante 14a, qui peut enrober des composants électroniques associés au résonateur 1 placé dans le boîtier, est coulée dans l'espace libre délimité par la paroi latérale cylindrique et la paroi plane supérieure 12 de l'embase.

Dans toute la présente description, on se référera à un boîtier disposé selon la figure 1 et les termes "inférieur, supérieur, vertical, horizontal," utilisés dans la présente description, sont à interpréter en liaison avec la description de cette figure 1 et visent à permettre une description des divers éléments dans leurs positions relatives à partir de la position de la figure 1. Le boîtier 10 peut naturellement être placé dans toutes sortes d'autres positions et lesdits termes "inférieur, supérieur, vertical, horizontal" ne doivent donc pas être considérés comme limitatifs en ce qui concerne la position du boîtier 10.

Le résonateur 1 peut être constitué par un cristal-résonateur à électrodes adhérentes, c'est-à-dire par une plaquette d'un matériau piézoélectrique de coupe donnée sur les faces principales de laquelle sont disposées des électrodes métalliques.

Le résonateur 1 peut toutefois être également constitué par un ensemble plus complexe, tel que celui représenté en élévation sur la figure 1, avec un cristal résonateur 101 constitué, comme dans le cas précédent, par une plaquette d'un matériau piézoélectrique par exemple du type bi-plan, mais démunie d'électrodes et présentant une couronne externe de support 110 délimitée par des lumières 111 et reliée à la partie centrale active du cristal par des ponts et deux plateaux 102, 103 présentant également chacun une partie périphérique de support qui porte sur la couronne externe 110 du cristal lui-même, de manière à former au niveau de cette couronne un empilement de surfaces ajustées les unes aux autres. Dans ce cas, les parties centrales 121, 131 des faces des plateaux 102, 103, situées en regard du cristal 101, et qui sont sans contact avec ce dernier portent des électrodes excitatrices dites électrodes non adhérentes 122, 132. L'ensemble compact constitué par le cristal 101 et les plateaux 102, 103 porteurs d'électrodes peut alors être considéré en bloc comme équivalent à un résonateur à électrodes adhérentes, les éléments du dispositif support de résonateur agissant dans ce cas sur les parties périphériques des plateaux supports d'électrode tandis que dans le cas d'un résonateur à électrodes adhérentes, le dispositif support est en contact avec la partie périphérique du cristal-résonateur lui-même.

Sur les figures 1 et 2, les références 123 et 133 désignent des chemins conducteurs reliant les électrodes 122, 132 à des plots 124, 134 respectivement destinés à permettre de constituer des liaisons électriques avec les broches de connexion 17, 18, 19 par des fils de liaison non représentés sur les dessins.

L'ensemble du dispositif de support selon l'invention est conçu de manière à être entièrement symétrique par rapport à deux plans axiaux du résonateur 1 perpendiculaires entre eux, ainsi que par rapport à un plan radial médian du résonateur 1 et à réaliser un découplage complet entre le boîtier de protection et le résonateur de façon que les actions dues aux perturbations extérieures (accélérations, chocs, vibrations, pression) ne puissent pas transmettre de moments de torsion ou de flexion au centre du cristal.

Les moyens de support sont en outre conçus de manière à comprendre un nombre limité de pièces et à être démontables.

Un premier élément constitutif des moyens de support du résonateur 1 dans le boîtier est constitué par une pièce cylindrique amovible 6, réalisée en acier, qui est disposée entre la paroi plane 12 de l'embase du boîtier, qui constitue le fond de la cavité formée à l'intérieur du boîtier, et la paroi supérieure 13 du capot du boîtier. La pièce cylindrique 6 est placée au voisinage de la paroi latérale cylindrique 11 du capot du boîtier et présente sur sa face interne une gorge 62 circulaire située dans un plan médian parallèle aux parois supérieure 13 et inférieure 12 du boîtier 10. La gorge 62 présente une forme annulaire à section rectangulaire et est destinée à recevoir par encliquetage des parties accolées d'une paire de ressorts 5 qui seront décrits plus loin. La pièce cylindrique 6 présente un épaulement 61 à l'une de ses extrémités pour ménager un espace libre 60 entre la paroi latérale 11 du boîtier 10 et la pièce cylindrique 6 sur la majeure partie de la hauteur de celle-ci.

Les moyens de support de l'ensemble du résonateur 1 qui, comme représenté sur les figures, peut être constitué d'un empilement de trois disques, à savoir deux disques 102, 103 supportant des électrodes et un disque central 101 constituant le résonateur proprement dit, comprennent quatre pinces indépendantes identiques 4 disposées à 90° les unes des autres, et coopérant directement avec les faces externes supérieure 126 et inférieure 136 du résonateur.

Chaque pince 4 présente la forme d'un U couché et comprend une partie verticale plane 41 dans la face arrière de laquelle sont formées deux rainures horizontales 46, 47 au voisinage des branches latérales 42, 43 de la pince 4.

Les forces de serrage appliquées par les quatre pinces 4 sont identiques, colinéaires et exercées perpendiculairement aux faces externes supérieure 126 et inférieure 136 du résonateur 1 de façon qu'aucun moment de flexion ne soit transmis à celui-ci.

Afin d'éviter les variations de compression dues aux pinces 4 lors des variations de température, on choisit pour les pinces un matériau dont le coefficient de dilatation est dans la direction axiale, identique à, ou très proche de celui du cristal 1. Pour un cristal en quartz, on peut ainsi choisir un matériau du type de celui connu sous la dénomination PHYNOX.

L'effet des dilatations différentielles transversales qui seraient dues aux différences des caractéristiques des matériaux est supprimé du fait de l'utilisation de quatre pinces indépendantes. Dans ces conditions, les dilatations radiales du cristal peuvent s'exercer librement.

La fonction "suspension" de l'ensemble cristal 1 avec ses disques 102, 103 support d'électrodes et les pinces 4 dans le boîtier 10 est assurée par huit ressorts 5 identiques qui relient les pinces 4 à la pièce cylindrique 6. La combinaison d'une pièce cylindrique 6 distincte du boîtier 10 et de ressorts 5 isole de façon efficace la partie sensible du résonateur 1 des actions extérieures appliquées au boîtier 10. Les ressorts 5 permettent en outre de compenser les défauts de fabrication entre les différents éléments assemblés.

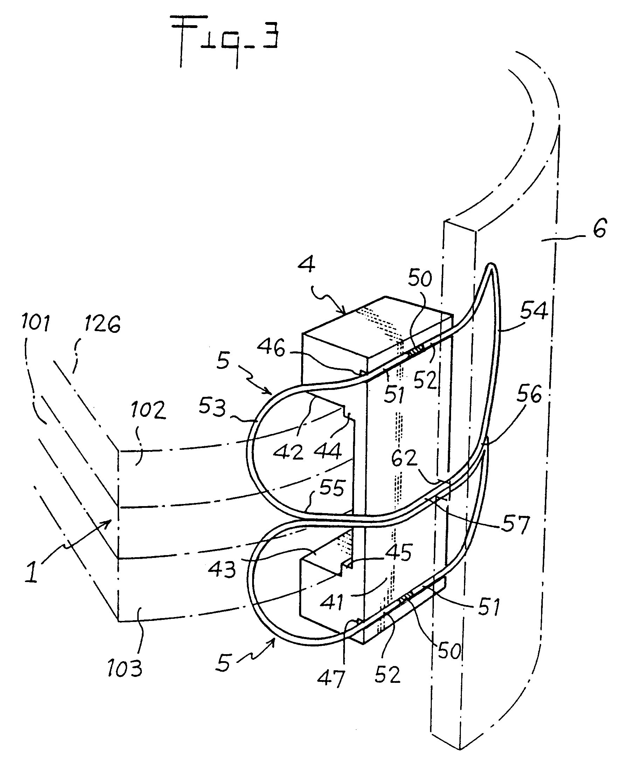

La suspension est conçue de manière symétrique pour que les actions dues aux perturbations extérieures (accélérations, chocs, vibrations, pression) ne soient pas susceptibles de transmettre des moments de torsion ou de flexion au centre du cristal. Huit ressorts de forme 5 sont ainsi disposés deux par deux à 90° les uns des autres, chaque paire de ressorts agissant sur les parties inférieure et supérieure d'une pince 4. La disposition des ressorts 5, leur forme particulière représentée sur les figures 1 à 3 et l'utilisation de fil rond de faible section, par exemple avec un diamètre de 2 dixièmes de millimètre, pour la réalisation des ressorts 5 permettent de garantir que le centre élastique de la suspension correspond avec le centre de gravité de la masse du système, que les trois degrés de liberté sont en translation, et qu'à ceux-ci sont associés trois coefficients de rigidité identiques.

Dans ces conditions, l'ensemble peut subir des chocs; c'est la suspension qui est capable de les "encaisser" et de minimiser leurs influences. Les ressorts 5 pouvant travailler à la torsion et à la flexion, il convient de choisir pour les réaliser un alliage spécial à haute limite élastique (par exemple un alliage du type connu sous la dénomination PHYNOX). Les ressorts 5 qui réalisent la liaison entre les pinces et la pièce cylindrique 6, peuvent être simplement encastrés dans la gorge 62 de la pièce cylindrique 6, de sorte que l'ensemble constitué des pinces 4 et des ressorts 5 peut être démonté par rapport à la pièce cylindrique 6, si nécessaire, et naturellement par rapport au résonateur 1.

Au niveau des pinces 4, la liaison avec les ressorts 5 peut être faite par soudure, le positionnement relatif étant assuré par les deux rainures 46, 47 taillées au dos de chaque pince 4.

De façon plus particulière, pour chaque paire de ressorts 5 coopérant avec une même pince 4, l'un des ressorts est engagé par une première portion 51, 52 dans la rainure supérieure 46 formée dans la face arrière plane 41 de la pince 4 à la partie supérieure de celle-ci, et par une seconde portion 57 dans la gorge circulaire 62 de la pièce cylindrique 6 tandis que l'autre ressort est engagé par une première portion 51, 52 dans la rainure inférieure 47 formée dans la face arrière plane 41 de la pince 4 à la partie inférieure de celle-ci et par une seconde portion 57 dans la gorge circulaire 62. Les secondes portions 57 des ressorts engagées dans la gorge circulaire 62 sont solidarisées entre elles par exemple par soudage au laser et se projettent en arrière par rapport à la face arrière 41 de la pince sur une distance comprise entre environ 1 et 2 mm et de préférence de l'ordre de 1,5 mm.

Les ressorts 5 présentent une interruption 50 au niveau de leur première portion 51, 52 engagée dans une rainure 46 ou 47 de la face arrière de la pince avec laquelle ils coopèrent. Les ressorts 5 sont symétriques par rapport à un plan situé au niveau de ladite interruption 50, qui correspond au plan médian vertical d'une pince 4. Chaque demi-ressort divisé par ledit plan de symétrie radial vertical comprend une première partie horizontale rectiligne 51; 52 destinée à venir s'encastrer dans une rainure 46 ou 47 de la pince réceptrice 4, une partie verticale courbe 53; 54 correspondant approximativement à une fraction de cercle disposée à l'extérieur de la pince réceptrice 4 dans un plan formant un angle de 45° par rapport au plan de symétrie du ressort, et une seconde partie horizontale 57 qui est reliée à l'extrémité 55; 56 de la partie verticale courbe 53; 54 éloignée de la première partie horizontale 51; 52 et constitue une partie de ladite seconde portion 57 située en arrière par rapport à la première partie horizontale rectiligne 51; 52 qui constitue elle-même une partie de ladite première portion.

Les faces internes 42, 43 des pinces 4 sensiblement perpendiculaires à la face arrière 41 présentent une surface régulière en contact avec les faces externes supérieure et inférieure 126, 136 des disques 102, 103 de support des électrodes du résonateur sur une zone s'étendant radialement sur une distance de l'ordre de 1 à 2 mm.

Des épaulements 44, 45 sont formés sur les pinces 4 au niveau du raccordement des faces internes 42, 43 sensiblement horizontales et de la face interne de la paroi arrière verticale.

Comme on peut le voir sur les figures 1 et 2, des évidements 125, 135 sont formés dans les parois des disques 102, 103 de support des électrodes du résonateur 1 dans des zones prolongeant radialement vers le centre du résonateur les zones au niveau desquelles les pinces 4 sont en contact avec les faces externes supérieure et inférieure 126, 136 des disques 102, 103 de support sur une distance de l'ordre de 1 à 2 mm, afin d'éviter que les pinces 4 qui sont directement en prise avec les parties périphériques des disques 102, 103 transmettent des contraintes aux parties centrales des disques 102, 103 et par suite du cristal 101 constituant le résonateur proprement dit.

## Revendications

1. Dispositif de support d'un résonateur piézoélectrique (1) à l'intérieur d'un boîtier (10),
comprenant quatre pinces (4) indépendantes identiques en forme de U qui sont réalisées en un matériau dont le coefficient de dilatation dans le sens axial du résonateur est pratiquement identique à celui du matériau constituant le résonateur et qui coopèrent chacune avec une paire de ressorts (5) constitués chacun par un fil métallique rond en un alliage à haute limite élastique, l'ensemble des pinces (4) et des ressorts (5) présentant une symétrie par rapport à deux plans axiaux du résonateur (1) perpendiculaires entre eux, ainsi que par rapport à un plan radial médian du résonateur (1),
caractérisé en ce qu'il comprend en outre une pièce cylindrique (6) amovible placée à l'intérieur du boîtier au voisinage de la paroi latérale (11) du boîtier (10), s'étendant sur toute la hauteur de l'espace interne défini entre les parois supérieure (13) et inférieure (12) du boîtier et présentant sur sa face interne une gorge (62) circulaire située dans un plan médian parallèle aux parois supérieure (13) et inférieure (12) du boîtier (10), en ce que pour chaque paire de ressorts (5) coopérant avec une même pince (4), l'un des ressorts est engagé par une première portion (51, 52) dans une rainure supérieure (46) formée dans la face arrière plane (41) de ladite pince (4) à la partie supérieure de celle-ci, et par une seconde portion (57) dans ladite gorge circulaire (62) tandis que l'autre ressort est engagé par une première portion (51, 52) dans une rainure inférieure (47) formée dans la face arrière plane (41) de ladite pince (4) à la partie inférieure à celle-ci, et par une seconde portion (57) dans ladite gorge circulaire (62), en ce que lesdites secondes portions (57) des ressorts engagées dans ladite gorge circulaire (62) sont solidarisées entre elles et se projettent en arrière par rapport à la face arrière (41) de ladite pince, et en ce que les faces internes (42, 43) des pinces (4) sensiblement perpendiculaires à la face arrière (41) desdites pinces reposent directement sur la périphérie des faces externes supérieure et inférieure (126, 136) du résonateur (1) ou des disques (102, 103) de support des électrodes (122, 132) du résonateur (1).

2. Dispositif selon la revendication 1, caractérisé en ce que la gorge circulaire (62) présente une forme annulaire à section rectangulaire.

3. Dispositif selon la revendication 1 ou la revendication 2, caractérisé en ce que la pièce cylindrique (6) est métallique et présente un épaulement (61) à l'une de ses extrémités pour ménager un espace libre (60) entre la paroi latérale (11) du boîtier (10) et la pièce cylindrique (6) sur la majeure partie de la hauteur de celle-ci.

4. Dispositif selon l'une quelconque des revendications 1 à 3, caractérisé en ce que lesdites secondes portions (57) des ressorts se projettent en arrière par rapport auxdites premières portions sur une distance comprise entre environ 1 et 2 mm et de préférence de l'ordre de 1,5 mm.

5. Dispositif selon l'une quelconque des revendications 1 à 4, caractérisé en ce que les pièces (4) et les ressorts (5) sont réalisés en un alliage métallique tel que celui connu sous la dénomination phynox.

6. Dispositif selon l'une quelconque des revendications 1 à 5, caractérisé en ce que les faces internes (42, 43) des pinces (4) sensiblement perpendiculaires à la face arrière (41) présentent une surface régulière en contact avec les faces externes supérieure et inférieure (126, 136) du résonateur (1) ou des disques (102, 103) de support des électrodes du résonateur (1) sur une zone s'étendant radialement sur une distance de l'ordre de 1 à 2 mm.

7. Dispositif selon l'une quelconque des revendications 1 à 6, caractérisé en ce que des épaulements (44, 45) sont formés sur les pinces (4) au niveau du raccordement des faces internes (41, 43) sensiblement horizontales et de la face interne de la paroi arrière verticale.

8. Dispositif selon l'une quelconque des revendications 1 à 7, dans lequel le résonateur (1) comprend des disques (102, 103) de support d'électrodes, caractérisé en ce que des évidements (125, 135) sont formés dans les parois des disques (102, 103) de support des électrodes du résonateur (1) dans des zones prolongeant radialement vers le centre du résonateur les zones au niveau desquelles les pinces (4) sont en contact avec les faces externes supérieure et inférieure (126, 136) des disques (102, 103) de support sur une distance de l'ordre de 1 à 2 mm.

9. Dispositif selon l'une quelconque des revendications 1 à 8, caractérisé en ce que les ressorts (5) présentent une interruption (50) au niveau de leur première portion (51, 52) engagée dans une rainure (46 ou 47) de la face arrière de la pince avec laquelle ils coopèrent, sont symétriques par rapport a un plan radial vertical situé au niveau de ladite interruption (50) et présentent une configuration telle que chaque demi-ressort divisé par ledit plan de symétrie radial vertical comprend une première partie horizontale rectiligne (51; 52) destinée à venir s'encastrer dans une rainure (46 ou 47) de la pince réceptrice (4), une partie verticale courbe (53; 54) disposée à l'extérieur de la pince réceptrice (4) dans un plan formant un angle de 45° par rapport au plan de symétrie du ressort, et une seconde partie horizontale (57) qui est reliée à l'extrémité (55; 56) de la partie verticale courbe (53; 54) éloignée de la première partie horizontale (51; 52) et constitue une partie de ladite seconde portion (57) située en arrière par rapport à la première partie horizontale rectiligne (51; 52) qui constitue elle-même une partie de ladite première portion.

10. Dispositif selon l'une quelconque des revendications 1 à 9, caractérisé en ce que les ressorts (5) sont constitués par des fils présentant un diamètre de l'ordre de 2 dixièmes de millimètre.

## Claims

1. Device for supporting a piezoelectric resonator (1) inside a casing (10),
comprising four independent and identical U-shaped coupling flanges (4) made of a material whose expansion coefficient in an axial direction with respect to said resonator is virtually identical to that of the material constituting the resonator, each coupling flange cooperating with a pair of springs (5), each of which is constituted of a circular cross-section metal wire made of a high yield strength alloy, the assembly constituted of coupling flanges (4) and springs (5) being symmetrical with respect to two mutually perpendicular axial planes of the resonator (1) and with respect to a center radial plane of the resonator (1),
characterized in that it further comprises a cylindrical element (6) which is displaceably mounted inside the casing in the vicinity of the lateral wall (11) of the casing (10), said element extending throughout the height of the inner space defined between the top (13) and bottom (12) walls of the casing and having on its inner face a circular groove (62) located in a center plane parallel to said top (13) and bottom (12) walls of the casing (10), in that for each pair of springs (5) cooperating with a common coupling flange (4), one of the springs is engaged by a first portion (51, 52) in a top slot (46) formed in the planar rear face (41) of said coupling flange (4) at the top portion thereof, and by a second portion (57) in said circular groove (62) while the other spring is engaged by a first portion (51, 52) into a bottom slot (47) formed in the planar rear face (41) of said coupling flange (4) at the bottom portion thereof, and by a second portion (57) inside said circular groove (62), in that said second portions (57) of the springs engaged in said circular groove (62) are joined together and project rearwardly with respect to the rear face (41) of said coupling flange, and in that the internal faces (42, 43) of the coupling flanges (4) which are substantially perpendicular to the rear face (41) of said coupling flanges rest directly on the periphery of the top and bottom external faces (126, 136) of the resonator (1) or of the disks (102, 103) supporting the electrodes (122, 132) of the resonator (1).

2. Device according to claim 1, characterized in that the circular groove (62) has an annular shape with a rectangular cross-section.

3. Device according to claim 1 or claim 2, characterized in that the cylindrical element (6) is metallic and has a shoulder (61) at one of its ends to provide a free space (60) between the lateral wall (11) of the casing (10) and the cylindrical element (6) on the major part of the height thereof.

4. Device according to any one of claims 1 to 3, characterized in that said second portions (57) of the springs project rearwardly with respect to said first portions over a distance of between about 1 and 2 mm and preferably of about 1.5 mm.

5. Device according to any one of claims 1 to 4, characterized in that the coupling flanges (4) and springs (5) are made of a metal alloy, such as the alloy known under the name of "Phynox".

6. Device according to any one of claims 1 to 5, characterized in that the internal faces (42, 43) of the coupling flanges (4) substantially perpendicular to the rear face (41) have a regular surface in contact with the top and bottom external faces (126, 136) of the resonator (1) or of the disks (102, 103) supporting the electrodes of the resonator (1) over a zone extending radially along a distance of about 1 to 2 mm.

7. Device according to any one of claims 1 to 6, characterized in that shoulders (44, 45) are formed on the coupling flanges (4) at the level where the substantially horizontal internal faces (41, 43) and the inner face of the rear vertical wall connect.

8. Device according to any one of claims 1 to 7, in which the resonator (1) comprises disks (102, 103) supporting the electrodes, characterized in that hollow portions (125, 135) are formed on the walls of the disks (102, 103) supporting the electrodes of the resonator (1) in zones that extend along a distance of about 1 to 2 mm radially towards the center of the resonator, those zones where said coupling flanges (4) are in contact with the top and bottom external faces (126, 136) of said supporting disks (102, 103).

9. Device according to any one of claims 1 to 8, characterized in that the springs (5) have a discontinuity (50) at the level of their first portion (51, 52) engaged in a slot (46 or 47) of the rear face of the coupling flange cooperating therewith, are symmetrical with respect to a vertical radial plane situated at the level of said discontinuity (50) and have a configuration such that each half-spring divided by said vertical radial symmetry plane comprises a first horizontal rectilinear portion (51; 52) intended to be lodged in a slot (46 or 47) of the receiving coupling flange (4), a curved vertical portion (53; 54) located outside the receiving coupling flange (4) in a plane forming a 45° angle with respect to the symmetry plane of the spring, and a second horizontal portion (57) joined to the end (55; 56) of the curved vertical portion (53; 54) that is distal with respect to the first horizontal portion (51; 52) and forms a part of said second portion (57) that is located at the rear with respect to the first horizontal rectilinear portion (51; 52) which itself forms a part of said first portion.

10. Device according to any one of claims 1 to 9, characterized in that the springs (5) are formed from wires having a diameter of about 2/10 mm.

## Patentansprüche

1. Vorrichtung zum Halten eines piezoelektrischen Resonators (1) in einem Gehäuse (10), bestehend aus vier unabhängigen, gleichen, U-förmigen Klemmen (4), die aus einem Material hergestellt sind, dessen Wärmedehnungskoeffizient in der axialen Richtung des Resonators praktisch gleich dem des Materials ist, das den Resonator bildet, und die jeweils mit einem Paar Federn (5) zusammenwirken, die jeweils aus einem runden Metalldraht aus einer Legierung mit einer hohen Elastizitätsgrenze bestehen, wobei die Anordnung aus den Klemmen (4) und den Federn (5) bezüglich zweier axialer Ebenen des Resonators (1), die zueinander senkrecht sind, ebenso wie bezüglich einer radialen Mittelebene des Resonators (1) symmetrisch ist,
**dadurch gekennzeichnet, daß** sie außerdem ein zylindrisches, abnehmbares Teil (6) aufweist, das im Gehäuse nahe der Seitenwand (11) des Gehäuses (10) angeordnet ist, das sich über die gesamte Höhe des Innenraums erstreckt, der zwischen den oberen und unteren Wänden (13, 12) des Gehäuses begrenzt ist, und das an seiner Innenseite eine kreisförmige Nut (62) aufweist, die in einer Mittelebene liegt, die zu den oberen und unteren Wänden (13, 12) des Gehäuses (10) parallel verläuft, daß für jedes Paar Federn (5), das mit einer selben Klemme (4) zusammenwirkt, die eine der Federn mit einem ersten Teil (51, 52) in eine obere Rille (46) eingreift, die an der ebenen Rückseite (41) dieser Klemme (4) an deren oberem Teil ausgebildet ist, und mit einem zweiten Teil (57) in die kreisförmige Nut (62), während die andere Feder mit einem ersten Teil (51, 52) in eine untere Rille (47) eingreift, die an der ebenen Rückseite (41) der Klemme (4) an deren unterem Teil ausgebildet ist und mit einem zweiten Teil (57) in die kreisförmige Nut (62), daß die zweiten Teile (57) der in die kreisförmige Nut (62) eingreifenden Federn miteinander verbunden sind und hinten bezüglich der Rückseite (41) der Klemme vorstehen, und daß die Innenseiten (42, 43) der Klemmen (4), die im wesentlichen senkrecht zur Rückseite (41) der Klemmen verlaufen, direkt auf den Umfang der oberen und unteren Außenseiten (126, 136) des Resonators (1) bzw. auf Scheiben (102, 103) zur Halterung der Elektroden (122, 132) des Resonators (1) aufliegen.

2. Vorrichtung nach Anspruch 1,
**dadurch gekennzeichnet, daß** die kreisförmige Nut (62) eine Ringform mit rechteckigem Querschnitt hat.

3. Vorrichtung nach Anspruch 1 oder 2,
**dadurch gekennzeichnet, daß** das zylindrische Teil (6) aus Metall besteht und einen Abstand (61) an einem seiner Enden zur Bildung eines freien Raums (60) zwischen der Seitenwand (11) des Gehäuses (10) und dem zylindrischen Teil (6) über dessen Hauptteil der Höhe aufweist.

4. Vorrichtung nach einem der Ansprüche 1 bis 3,
**dadurch gekennzeichnet, daß** die zweiten Teile (57) der Federn hinten bezüglich der ersten Teile um eine Strecke vorstehen, die zwischen etwa 1 und 2 mm und vorzugsweise in der Größenordnung von 1,5 mm liegt.

5. Vorrichtung nach einem der Ansprüche 1 bis 4,
**dadurch gekennzeichnet, daß** die Teile (4) und die Federn (5) aus einer Metall-Legierung wie die unter der Bezeichnung Phynox bekannten bestehen.

6. Vorrichtung nach einem der Ansprüche 1 bis 5,
**dadurch gekennzeichnet, daß** die Innenseiten (42, 43) der Klemmen (4), die im wesentlichen senkrecht zur Rückseite (41) verlaufen, eine gleichmäßige Oberfläche haben, die mit dem oberen und unteren Außenseiten (126, 136) des Resonators (1) bzw. den Scheiben (102, 103) zur Halterung der Elektroden des Resonators (1) über eine Zone, die sich radial über eine Strecke in der Größenordnung von 1 bis 2 mm erstreckt, in Berührung stehen.

7. Vorrichtung nach einem der Ansprüche 1 bis 6,
**dadurch gekennzeichnet, daß** Absätze (44, 45) an den Klemmen (4) in der Höhe der Verbindung der im wesentlichen horizontalen Innenseiten (41, 43) und der Innenseite der vertikalen Rückwand ausgebildet sind.

8. Vorrichtung nach einem der Ansprüche 1 bis 7, wobei der Resonator (1) Scheiben (102, 103) zur Halterung der Elektroden aufweist,
**dadurch gekennzeichnet, daß** Ausnehmungen (125, 135) in den Wänden der Scheiben (102, 103) zur Halterung der Elektroden des Resonators (1) in Zonen ausgebildet sind, die radial zur Mitte des Resonators die Zonen verlängern, in deren Höhe die Klemmen (4) mit den oberen und unteren Außenseiten (126, 136) der Scheiben (102, 103) der Halterung auf einer Strecke in der Größenordnung von 1 bis 2 mm in Berührung stehen.

9. Vorrichtung nach einem der Ansprüche 1 bis 8,
**dadurch gekennzeichnet, daß** die Federn (5), die eine Unterbrechung (50) in der Höhe ihres ersten Teils (51, 52) aufweisen, der in eine Rille (46 oder 47) der Rückseite der Klemme eingreift, mit der sie zusammenwirken, bezüglich einer radialen vertikalen Ebene, die in der Höhe der Unterbrechung (50) liegt, symmetrisch sind und eine solche Form haben, daß jede Halbfeder, die in der Höhe der Unterbrechung (50) liegt, symmetrisch sind und eine solche Form haben, daß jede Halbfeder, die durch die radiale vertikale Symmetrieebene geteilt wird, einen ersten horizontalen geraden Teil (51; 52) aufweist, der dazu bestimmt ist, in eine Rille (46 oder 47) der Aufnahmeklemme (4) einzugreifen, einen vertikalen gebogenen Teil (53; 54), der außerhalb der Aufnahmeklemme (4) in einer Ebene angeordnet ist, der einen Winkel von 45° bezüglich der Symmetrieebene die Feder bildet, und einen zweiten horizontalen Teil (57), der mit dem Ende (55, 56) des vertikalen gebogenen Teils (53; 54) verbunden ist, das vom ersten horizontalen Teil (51; 52) entfernt ist und einen Abschnitt des zweiten Teils (57) bildet, der hinten bezüglich des ersten horizontalen geraden Teils (51; 52) liegt, der selbst einen Abschnitt des ersten Teils bildet.

10. Vorrichtung nach einem der Ansprüche 1 bis 9,
**dadurch gekennzeichnet, daß** die Federn (5) aus Drähten bestehen, die einen Durchmesser in der Größenordnung von 0,2 mm haben.
